# EUROPEAN PATENT SPECIFICATION

(11) **EP 1 204 166 B1**
(45) Date of publication and mention of the grant of the patent: **29.12.2004**
(21) Application number: 01124345.8
(22) Date of filing: 22.10.2001
(51) Int. Cl.: H01R 11/28, H01R 13/66

(54) **Battery terminal unit with current sensor**
Batterieklemme mit Stromsensor
Cosse de connection pour batterie avec mesureur de courant

(30) Priority: 01.11.2000 JP 2000334858
(43) Date of publication of application: 08.05.2002
(73) Proprietor: Sumitomo Wiring Systems, Ltd., Yokkaichi-City, Mie, 510-8503 (JP)
(72) Inventor: Wakata, Shigekazu, Sumitomo Wiring Systems, Ltd., Yokkaichi-City, Mie 510-8503 (JP); Wakui, Masanori, Toyota-shi, Aichi-ken 471-8572 (JP); Niwa, Hisao, Toyota-shi, Aichi-ken 471-8572 (JP); Okubo, Naohiko, Toyota-shi, Aichi-ken 471-8572 (JP)
(74) Representative: Müller-Boré & Partner Patentanwälte

(56) References cited:
- FR-A- 2 293 073
- FR-A- 2 702 310

## Description

The present invention relates to a battery terminal unit provided with a current sensor.

The kinds and number of electric parts of a vehicle have recently kept on increasing and, accordingly, electric energy produced by a vehicle battery has been more intensely exhausted. Thus, there has been a demand for monitoring a remaining capacity of the battery. In such a case, a current sensor may be mounted on a battery post and a degree of exhaustion of the battery may be detected depending on the intensity of a current detected thereby.

However, there is no sufficient space to mount the current sensor around the battery post of the existing battery. Even if the current sensor is mounted on a wiring harness to be connected with battery post, there is still a problem that it may be easily broken upon being struck against something in consideration of how the wiring harness is handled.
FR-A-2 293 073 discloses a battery terminal unit comprising a current sensor. The current sensor is mounted on the wire of the battery terminal in a predetermined distance, such that there exists no space problem around the battery post.

The present invention was developed in view of the above situation and an object thereof is to provide a battery terminal unit provided with a current sensor, which current sensor may not easily be damaged when handling the wiring harness and has an excellent mountability.

This object is solved according to the invention by a battery terminal unit according to claim 1. Preferred embodiments are subject of the dependent claims.

According to the invention, there is provided a battery terminal unit provided with a current sensor, wherein a terminal unit is formed of a wire or wiring harness, a battery terminal having at least one terminal portion provided at a leading end side of the wire or wiring harness and connectable with a battery post, and a holder mounted or mountable on the wiring harness or battery terminal at a position distanced or spaced at a distance from the terminal portion, and a current sensor is mountable preferably mounted later on the holder of the terminal unitby means of a sensor portion having locking means being cooperable with mating locking means of the holder.

Accordingly, since the holder is provided at the position distanced from the terminal portion of the battery terminal, the current sensor can be smoothly mounted without being hindered by anything around.

Further, since the current sensor is mounted later on the terminal unit, i.e. it is connected with the wiring harness at a connection site to a battery, it will not be damaged while the wiring harness is being handled.

According to a preferred embodiment, the holder is substantially ring-shaped and is mounted or mountable by introducing the wire or wiring harness therethrough, and the current sensor is preferably formed such that it can be coupled to the holder after introducing the terminal portion of the battery terminal therethrough.

Accordingly, since the holder is mounted on the wiring harness, the battery terminal needs not be formed with a special portion for mounting the holder. Therefore, a terminal having an existing construction can be used as the battery terminal.

Preferably, the battery terminal comprises a holder mount portion extending from the terminal portion toward the wire or wiring harness and to be connected with the wire or wiring harness, the holder is mounted on the holder mount portion at the position distanced from the terminal portion, and the current sensor is preferably formed such that it can be coupled to the holder after introducing the terminal portion of the battery terminal therethrough.

Accordingly, the holder is mounted on the holder mount portion provided at the battery terminal, and the current sensor is mountable or mounted on the holder after being put on the battery terminal from the side of the terminal portion.

Further preferably, the holder is formed by two half-pieces being arrangeable on the wire or wiring harness or the battery terminal by being fixed preferably interlocked to each other.

Still further preferably, the holder is formed by insert-molding on the holder mount portion.

According to a further preferred embodiment of the invention, the distance is sufficient for a tightening means of the battery terminal to be tightened so that the battery terminal can be connected to the external battery post.

Preferably, the battery terminal comprises a barrel portion for connection with the wire or wiring harness preferably by crimping.

Most preferably, the holder is in the form of a bottomed ring.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is an exploded perspective view of a first embodiment,
FIG. 2 is a perspective view showing a state where a current sensor is mounted on a terminal unit,
FIG. 3 is a perspective view showing a state where a holder is mounted on a wiring harness,
FIG. 4 is an exploded perspective view of a second embodiment, and
FIG. 5 is a perspective view showing a state where a current sensor is mounted on a terminal unit.

Hereinafter, preferred embodiments of the present invention are described with reference to the accompanying drawings.

### - First Embodiment -

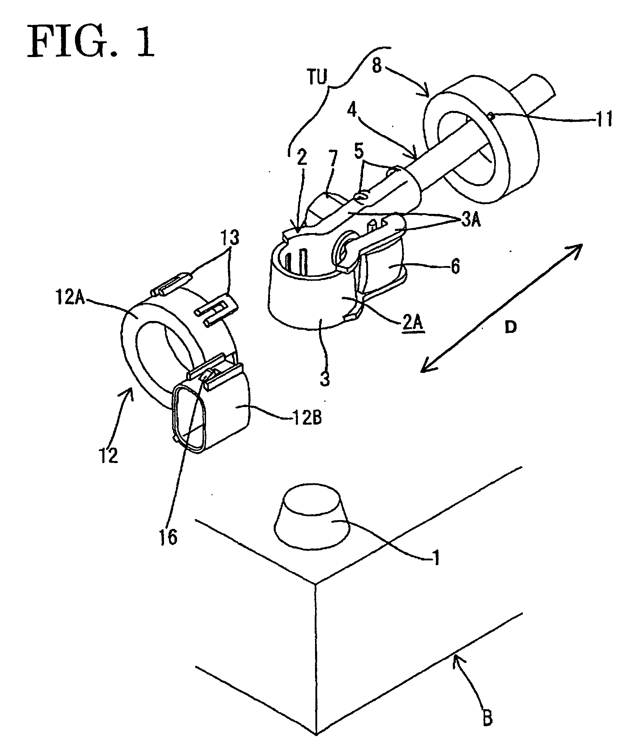

FIGS. 1 to 3 show a first preferred embodiment of the present invention. In FIG. 1, identified by B is a battery mounted or mountable e.g. in an automotive vehicle, and a pair of battery posts 1 (lead electrodes) stand on the upper surface thereof (only one battery post is shown in FIG 1). Each battery post 1 is in the formed of a truncated cone slightly tapered toward the top and a battery terminal 2 is to be connected therewith.

The battery terminal 2 has a known construction. Specifically, it is formed by bending an electrically conductive metallic plate and has a terminal portion 2A to be connected with the battery post 1. This terminal portion 2A has a fastening ring or bent portion 3 to be fastened to or substantially around the battery post 1. The fastening ring 3 is formed into such a substantially tubular or ring-shaped or bent shape as to be substantially closely fittable to or on the outer circumferential surface of the battery post 1 and is open upward and downward or along a fitting direction of the battery terminal 2 onto the respective battery post 1. Further. Opposite ends of the fastening ring 3 extend sideways to substantially oppose to each other, thereby forming opposed walls 3A. A clamp bolt 6 for tightening the fastening ring 3 horizontally or laterally penetrates between and through the opposed walls 3A. This clamp bolt 6 preferably has a rectangular or polygonal head, which is engaged or engageable with the upper and lower edges of one of the opposed walls 3A to prevent further turning. A nut 7 is or can be engaged at or threaded to an end of a shaft of the clamp bolt 6. The opposed walls 3A are brought or bringable closer to each other by tightening the clamp bolt 6 and the nut 7, thereby tightening the fastening ring 3 to cause the fastening ring 3 to engage, preferably to bite in the battery post 1.

The other opposed wall 3A extends further backward or laterally to become a barrel portion 5 for the connection with a wire or cable or wiring harness 4. Although not shown in detail, the barrel portion 5 includes a portion to be crimped into connection with a core exposed by stripping the leading end of the wiring harness 4 and a portion to be crimped into connection with an insulation coating of the wiring harness 4.

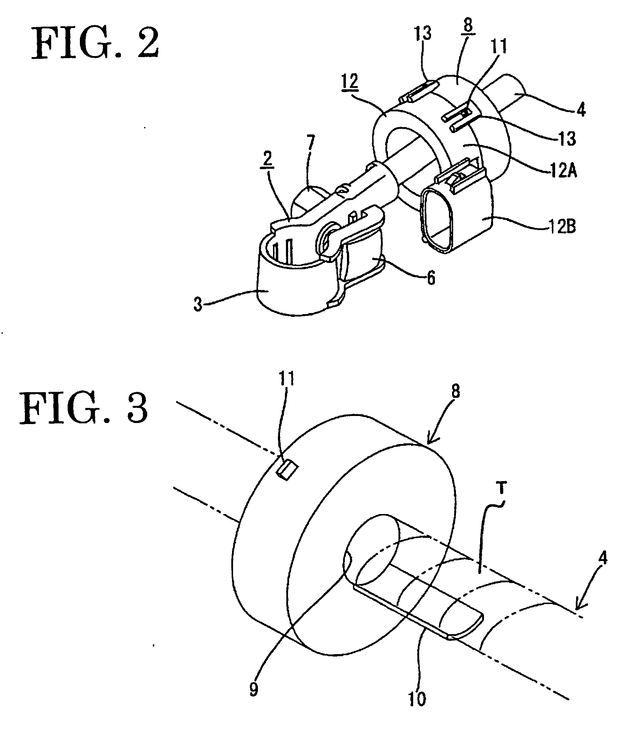

A holder 8 in the form of a bottomed ring (i.e. a ring having at one leading end a projecting portion axially projecting inwardly so as to define an insertion hole 9 to be described later) is provided at an intermediate position of the wiring harness 4 distanced from the battery terminal 2 by a specified distance D (preferably such a distance D that a tool does not interfere when the nut 7 is tightened thereby). The holder 8 is made e.g. of a synthetic resin, and an insertion hole 9 for permitting the insertion of the wiring harness 4 is formed in the center of its bottom wall. Further, as shown in FIG. 3, a receiving piece 10 extends outward along longitudinal direction at the opening edge of the insertion hole 9, and the wiring harness 4 is fixed, preferably taped by taping means T while being supported by the receiving portion 10. In this way, a terminal unit TU in which the holder 8 is assembled with the wiring harness 4 connected with the battery terminal 2 into one unit is constructed. Locking means i.e. in the form of a plurality of locking projections 11 are formed at suitable intervals on the outer circumferential surface of the holder 8 near one of its edges.

A current sensor 12 is comprised of a sensor portion 12A having an unillustrated built-in detector using, for example, a Hall device or the like for detecting a current supplied from the battery B to a load connected with the wiring harness 4, and a connector portion 12B integrally or unitarily projecting from one side of the sensor portion 12A. The ring-shaped detector is or can be embedded in the sensor portion 12A preferably by insert-molding of a synthetic resin. Further, the sensor portion 12A is formed such that the battery terminal 2 can be fitted sideways, and locking means i.e. in the form of a plurality of locking pieces 13 are so provided on its outer circumferential surface as to substantially correspond to and thus being cooperable with the respective locking projections 11 of the holder 8. The respective locking pieces 13 are substantially U-shaped, and extend in a direction toward the holder 8. When the holder 8 and the sensor portion 12A are substantially aligned and put together, the locking projections 11 can be located inside the corresponding locking pieces 13 so as to cooperate or interact therewith. In this way, the current sensor 12 can be mounted on the terminal unit TU.

The connector portion 12B is integrally or unitarily molded with the sensor portion 12A so as to be substantially continuous with the one side of the sensor portion 12A and has a tubular shape which preferably is open at one side, and a terminal fitting connected with the aforementioned ring-shaped detector is mounted or mountable therein. The connector portion 12B is or can be fitted to a mating connector connected with an unillustrated current detecting circuit to enable terminal fittings mounted inside to be electrically connected with each other. A locking claw 16 for holding the connector portion 12B connected with the mating connector projects from the upper or lateral surface of the connector portion 12B.

The first embodiment is constructed as above. The terminal unit TU including the holder 8 and the current sensor 12 are transported to a connection site where they are connected with a battery.

At the connection site, the sensor portion 12A of the current sensor 12 is fitted on the battery terminal 2, and the holder 8 and the sensor portion 12A are put together while being substantially aligned with each other. The current sensor 12 is mounted on the holder 8 by engaging the respective locking pieces 13 with the corresponding locking projections 11.

Upon completion of mounting of the current sensor 12, the fastening ring 3 of the battery terminal 2 is fitted to the battery post 1 and the clamp bolt 6 is tightened in this state. Then, the fastening ring 3 is tightened and its inner circumferential surface engages and preferably bites in the battery post 1. In this way, connection of the battery terminal 2 with the battery post 1 is completed.

It should be noted that a current flowing between the battery B and the load is detected by the ring-shaped detector, and a degree of exhaustion of the battery B can be judged based on a detected value.

As described above, according to this embodiment, the current sensor 12 is mounted or mountable on the holder 8 at a position distanced from the terminal portion 2A of the battery terminal 2, i.e. at a position where nothing that hinders the mounting operation is around. Thus, the mounting operation can be smoothly performed. Further, since the holder 8 and the current sensor 12 can be connected only by being manually pushed against each other by an operator to elastically or resiliently engage the locking pieces 13 and the locking projections 11 with each other, no tool is required. The mounting operation is simpler in this respect as well.

Further, the current sensor 12 is transported to the connection site without being mounted on the wiring harness 4, and is mounted on the terminal unit TU at the connection site. Therefore, the current sensor 12 will not be damaged while the wiring harness 4 is being handled.

Furthermore, since the holder 8 is mounted on the wiring harness 4 in the first embodiment, there is an additional advantage that a terminal having an existing construction can be used as the battery terminal 2.

Besides taping T as in this embodiment, various methods including molding and adhesion by an adhesive may be adopted as a means for fixing the holder 8 to the wiring harness 4.

### - Second Embodiment -

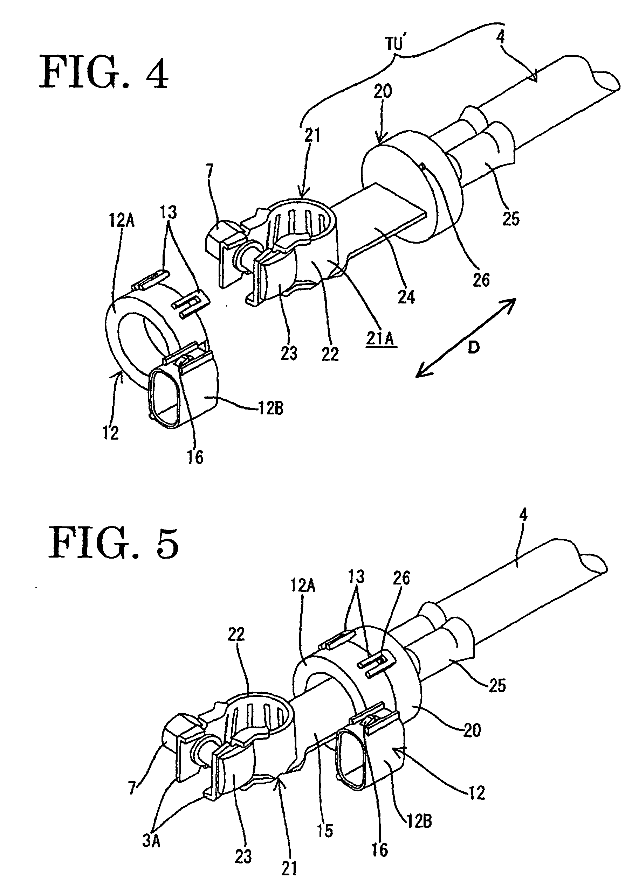

FIGS. 4 and 5 show a second preferred embodiment of the present invention. The second embodiment is identical to the first embodiment in the construction of the current sensor 12, but differs therefrom in the construction of a battery terminal 21 because a holder 20 is mounted or mountable on the battery terminal 21.

In the battery terminal 21 of this embodiment, a holder mount portion 24 substantially in the form of a plate or flat portion integrally or unitarily extends from the bottom edge of a side of a fastening ring 22 substantially opposite from the side where a clamp bolt 23 is provided. Further, a barrel portion 25 is provided at the leading end of the holder mount portion 24 and is connected or connectable with a core and an insulation coating of the wire or wiring harness 4 preferably by crimping. A holder 20 made e.g. of a synthetic resin is formed preferably by insert-molding at a position of the holder mount portion 24 near the barrel portion 25 (alternatively, the holder 20 may be made up of two half pieces substantially divided along a diameter, and may be mounted by preferably being adhered with the holder mount portion 24 located therebetween or by being interlocked by locking means with the holder mount portion 24 arranged therebetween). Accordingly, the holder 20 is or can be positioned at a distance D from the respective terminal portion 21A. The holder 20 is substantially disk-shaped, and a plurality of locking projections 26 are formed surface at suitable intervals on its outer circumferential surface.

In the second embodiment thus constructed, the holder 20 is integrally or unitarily formed with the battery terminal 21 preferably by insert-molding, thereby constructing a terminal unit TU' as a whole. Thus, as in the first embodiment, the current sensor 12 and the terminal unit TU' are separately transported. At a connection site to a battery, the current sensor 12 is or can be fitted from the terminal portion 21A of the battery terminal 21, and the sensor portion 12A and the holder 20 are substantially aligned to engage the locking pieces 13 and the locking projections 26 with each other, thereby completely mounting the current sensor 12. If the fastening ring 22 is fastened to the battery post 1 substantially in the same manner as in the first embodiment thereafter, the connecting operation to the battery is completed.

In the second embodiment as well, the current sensor 12 can be mounted at a position distanced from the battery B where nothing that hinders the operation is around. Thus, a smooth operation can be expected. Further, since the current sensor 12 is first mounted on the wiring harness 4 prior to connection with the battery B instead of being connected therewith beforehand, it will not be damaged while the wiring harness 4 is being handled.

Various changes can be made in the present invention, and a following embodiment is also embraced by the technical scope of the present invention as defined in the claims.
(1) Although the current sensor 12 shown is internally provided with the ring-shaped detector, the shape and mode thereof can be changed in various manners and are not limited to those of the foregoing embodiment.

## Claims

1. A battery terminal unit provided with a current sensor (12), wherein said terminal unit (TU: TU') is formed of a wire or wiring harness (4), a battery terminal (2; 21) having at least one terminal portion (2A; 21A) provided at a leading end side of the wire or wiring harness (4) and connectable with a battery post (1), and a holder (8; 20) mountable on the wire or wiring harness (4) or battery terminal (21) at a position distanced at a distance (D) from the terminal portion (2A; 21A), and wherein said current sensor (12) is mountable on the holder (8; 20) of the terminal unit (TU; TU');
**characterized in that**
the current sensor (12) is mounted onto the holder by means of a sensor portion (12A) having locking means (13) being cooperable with mating locking means (11; 26) of the holder (8; 20).

2. The subject-matter according to claim 1, wherein the holder (8) is substantially ring-shaped and is mountable by introducing the wire or wiring harness (4) therethrough.

3. The subject-matter according to one or more of the preceding claims, wherein the battery terminal (21) comprises a holder mount portion (24) extending from the terminal portion (21A) toward the wire or wiring harness (4) and connected with the wire or wiring harness (4), the holder (20) is mountable on the holder mount portion (24) at the position distanced from the terminal portion(21A).

4. The subject-matter according to one or more of the preceding claims, wherein the holder (8; 20) is formed by two half-pieces being arrangeable on the wire or wiring harness (4) or the battery terminal (21) by being fixed preferably interlocked to each other.

5. The subject-matter according to claim 3, wherein the holder (20) is formed by insert-molding on the holder mount portion (24).

6. The subject-matter according to one or more of the preceding claims, wherein the current sensor (12) is formed such that it can be coupled to the holder (8; 20) after introducing the terminal portion (2A; 21A) of the battery terminal (2; 21) therethrough.

7. The subject-matter according to one or more of the preceding claims, wherein the distance (D) is sufficient for a tightening means (7; 6; 21) of the battery terminal (2; 21) to be tightened so that the battery terminal (2; 21) can be connected to the external battery post (1).

8. The subject-matter according to one or more of the preceding claims, wherein the battery terminal (2; 21) comprises a barrel portion (5; 25) for connection with the wire or wiring harness (4) preferably by crimping.

9. The subject-matter according to one or more of the preceding claims, wherein the holder (8; 21) is in the form of a bottomed ring.

## Patentansprüche

1. Batterieklemme bzw. Batterieanschlußeinheit, welche mit einem Stromsensor (12) versehen ist, wobei die Anschlußeinheit (TU: TU') gebildet ist aus einem Draht oder einer Verkabelung bzw. einem Kabelbaum (4), einen Batterieanschluß (2; 21), welcher wenigstens einen Anschluß- bzw. Kontaktabschnitt (2A; 21A) aufweist, welcher an einer vorderen Endseite des Drahts oder der Verkabelung (4) vorgesehen ist und mit einem Batteriepol (1) verbindbar ist, und einer Halterung bzw. Halteeinrichtung (8; 20), welche an dem Draht oder der Verkabelung (4) oder dem Batterieanschluß (21) an einer Position beabstandet um einen Abstand (D) von dem Anschlußabschnitt (2A; 21A) montierbar ist, und wobei der Stromsensor (12) an der bzw. die Halterung (8; 20) der Anschlußeinheit (TU; TU') montierbar ist,
**dadurch gekennzeichnet, daß**
der Stromsensor (12) an der Halterung mittels eines Sensorabschnitts (12) montiert bzw. angeordnet ist, welcher verriegelnde bzw. Verriegelungsmittel (13) aufweist, welche mit zusammenpassenden verriegelnden Mittel (11; 26) der Halterung (8; 20) zusammenwirken.

2. Gegenstand nach Anspruch 1, wobei die Halterung (8) im wesentlichen ringförmig ist und montierbar ist, indem der Draht oder die Verkabelung (4) dadurch eingeführt sind bzw. werden.

3. Gegenstand nach einem oder mehreren der vorangehenden Ansprüche, wobei der Batterieanschluß (21) einen Halterungs-Montageabschnitt (24) umfaßt, welcher sich von dem Anschlußabschnitt (21A) zu dem Draht oder der Verkabelung (4) erstreckt und mit dem Draht oder der Verkabelung (4) verbunden ist, wobei die Halterung (20) an dem Halterungs-Montageabschnitt (24) an der Position beabstandet von dem Anschlußabschnitt (21A) montierbar ist.

4. Gegenstand nach einem oder mehreren der vorangehenden Ansprüche, wobei die Halterung (8; 20) durch zwei Halbstücke gebildet ist, welche an dem Draht oder der Verkabelung (4) oder dem Batterieanschluß (21) anordenbar sind, indem sie aneinander fixiert vorzugsweise in- bzw. miteinander verriegelt sind.

5. Gegenstand nach Anspruch 3, wobei die Halterung (20) durch Inserttechnik bzw. -Formgebung auf dem Halterungs-Montageabschnitt (24) ausgebildet ist bzw. wird.

6. Gegenstand nach einem oder mehreren der vorangehenden Ansprüche, wobei der Stromsensor (12) derart ausgebildet ist, daß er mit der Halterung (8; 20) nach einem Einführen des Anschlußabschnitts (2A; 21A) des Batterieanschlusses (2; 21) dadurch gekoppelt werden kann.

7. Gegenstand nach einem oder mehreren der vorangehenden Ansprüche, wobei der Abstand (D) ausreichend für eine Befestigung- bzw. Festlegungsmittel (7; 6; 21) des Batterieanschlusses (2; 21) ist, um festgelegt bzw. angezogen zu werden, so daß der Batterieanschluß (2; 21) mit dem externen Batteriepol (1) verbunden werden kann.

8. Gegenstand nach einem oder mehreren der vorangehenden Ansprüche, wobei der Batterieanschluß (2; 21) einen Rohr- bzw. Trommel- bzw. Hülsenabschnitt (5; 25) für eine Verbindung mit dem Draht oder der Verkabelung (4) vorzugsweise durch ein Crimpen umfaßt.

9. Gegenstand nach einem oder mehreren der vorangehenden Ansprüche, wobei die Halterung (8; 21) in der Form eines mit einem Boden versehenen Rings ausgebildet ist.

## Revendications

1. Cosse de batterie comportant un mesureur de courant (12), dans laquelle la dite cosse (TU, TU') est constituée d'un câble ou d'un faisceau de câbles (4), d'une borne de batterie (2; 21) ayant au moins une partie terminale (2A ; 21A) prévue d'un côté d'extrémité de tête du câble ou du faisceau de câbles (4) et connectable à un pôle de batterie (1), et d'une monture (8 ; 20) qui peut être montée sur le câble ou le faisceau de câbles (4) ou la borne de batterie (21) à une position éloignée à une distance (D) de la partie terminale (2A ; 21A), et dans laquelle le dit mesureur de courant (12) peut être fixé sur la monture (8 ; 20) de la cosse (TU ; TU')
**caractérisée en ce que** le mesureur de courant (12) est fixé sur la monture au moyen d'une partie de détection (12A) comportant des moyens de verrouillage (13) qui peuvent coopérer avec des moyens de verrouillage complémentaires (11 ; 26) de la monture (8 ; 20).

2. Cosse selon la revendication 1, dans laquelle la monture (8) est sensiblement annulaire et elle peut être montée par introduction du câble ou du faisceau de câbles (4) à travers elle.

3. Cosse selon une ou plusieurs des revendications précédentes, dans laquelle la borne de batterie (21) comprend une partie de fixation de monture (24) s'étendant à partir de la partie terminale (21A) vers le câble ou le faisceau de câbles (4) et reliée au câble ou au faisceau de câbles (4), la monture (20) pouvant être fixée sur la partie de fixation de monture (24) à la position distante de la partie terminale (21A).

4. Cosse de batterie selon une ou plusieurs des revendications précédentes, dans laquelle la monture (8 ; 20) est constituée de deux moitiés qui peuvent être placées sur le câble ou le faisceau de câbles (4) ou la borne de batterie (21) et fixées l'une à l'autre de préférence de façon verrouillée.

5. Cosse selon la revendication 3, dans laquelle la monture (20) est formée par moulage d'insert sur la partie de fixation de monture (24).

6. Cosse selon une ou plusieurs des revendications précédentes, dans laquelle le mesureur de courant (12) est formé de sorte qu'il peut être couplé à la monture (8 ; 20) après introduction de la partie terminale (2A ; 21A) de la borne de batterie (2 ; 21) à travers lui.

7. Cosse selon une ou plusieurs des revendications précédentes, dans laquelle la distance (D) est suffisante pour qu'on puisse bloquer un moyen de serrage (7 ; 6 ; 21) de la borne de batterie (2 ; 21) de sorte que la borne de batterie (2 ; 21) peut être connectée au pôle de batterie extérieur (1).

8. Cosse selon une ou plusieurs des revendications précédentes, dans laquelle la borne de batterie (2 ; 21) comprend une partie tubulaire (5 ; 25) pour connexion au câble ou au faisceau de câbles (4) de préférence par sertissage.

9. Cosse selon une ou plusieurs des revendications précédentes, dans laquelle la monture (8 ; 21) est sous la forme d'un anneau ayant un fond.
